Europäisches Patentamt

**(19)** European Patent Office

Office européen des brevets

**(11)** Publication number: **0 097 148**
**B1**

**(12)** EUROPEAN PATENT SPECIFICATION

**(45)** Date of publication of patent specification: **30.12.86**

**(51)** Int. Cl.⁴: **G 11 C 19/00,** G 06 F 1/04, G 06 F 11/20

**(21)** Application number: **82900121.3**

**(22)** Date of filing: **21.12.81**

**(86)** International application number:
**PCT/GB81/00281**

**(87)** International publication number:
**WO 83/02357 07.07.83 Gazette 83/16**

**(54) IMPROVEMENTS IN OR RELATING TO WAFER SCALE INTEGRATED CIRCUITS.**

| | |
|---|---|
| **(43)** Date of publication of application: **04.01.84 Bulletin 84/01** | **(73)** Proprietor: BURROUGHS CORPORATION (a Delaware corporation) Burroughs Place Detroit Michigan 48232 (US) |
| **(45)** Publication of the grant of the patent: **30.12.86 Bulletin 86/52** | **(73)** Proprietor: BURROUGHS MACHINES LIMITED Heathrow House, Bath Road Cranford Hounslow Middlesex TW5 9QL (GB) |
| **(84)** Designated Contracting States: **BE DE FR NL SE** | **(72)** Inventor: OSMAN, Ismet Mohammad Fazil Mahomed 920 Begonia Street Escondido, CA 92027 (US) |
| **(56)** References cited: WO-A-82/02451 GB-A-2 021 825 US-A-3 913 072 US-A-4 229 699 | **(74)** Representative: Kirby, Harold Douglas Benson et al G. F. Redfern & Company Marlborough Lodge 14 Farncombe Road Worthing West Sussex BN11 2BT (GB) |

Courier Press, Leamington Spa, England.

## Description

The present invention relates to wafer scale integrated circuits.

A wafer scale integrated circuit generally comprises one or more data ports together with many data processing cells all on the same semiconducting wafer, usually several inches in diameter. In order that the cell fabrication failure rate may be accommodated on the wafer, the interconnection between the cells is left indeterminate, each cell being provided by means whereby it can be coupled to any selectable neighbouring cell. Starting at one or more of the ports, cells neighbouring the port or ports are tested and if functional, coupled to the port or ports. Thereafter, the coupled cell or cells couple to and test neighbouring cells which are similarly incorporated if they prove functional. Cells which do not pass the functional test are not coupled into the overall operation of the circuit another cell being found to take their place. At the end of the test and coupling process one or more data processing chains of cells is established across the face of the wafer scale integrated circuit.

A cell may fail its functional testing because of a fabrication fault peculiar to that cell. This kind of fault is well known in integrated circuit fabrication where this results in a rejected chip prior to the packaging stage. In the case of water scale integrated circuits the consequences can be more serious.

It is in the nature of water scale integrated circuits that certain signals are propagated between cells and certain signals are common to all cells. For example, data signals are generally propagated from one particular cell to another, while the power supply and clock synchronisation signals are generally common to all cells. The common signals are generically known as Global signals and are distributed about the wafer scale circuit on Global lines.

A fault on a Global line can affect more than one cell. For example, a broken or short circuit power supply line can disable not only that cell where the fault physically occurs but also many adjacent cells also dependent upon that particular line for their power supply.

Various schemes have been proposed whereby the effects of Global line faults can be reduced. In particular, power lines can be prevented from disabling more than one cell in the presence of a short circuit by the inclusion therein of fusible isolation links which melt when they carry excess current. Such measures are acceptable in lines carrying sufficient power to melt links and the like, but in the case of other Global signal lines there is not the energy available to achieve such protection.

It is therefore desirable, in order to maximise the number of functionally useful cells on a wafer scale integrated circuit, to minimise the number of low power Global signal lines thereon.

International Patent Application WO—A—82—02451 is taken in this application as closest background art and falls within the terms of article 54 paragraph 3 of the European patent Convention, being earlier filed, co-pending prior art whereover the matter of this application is required to show novelty but is not required to display an inventive step.

WO—A—82—02451 discloses a wafer-scale integrated circuit wherein a plurality of cells on a semiconductor wafer are selectably operable, starting at a port, to be coupled to from the port, and then successively to one another, to form a data processing chain down which data and commands can be sent and wherein each cell has been tested and found working. A clock signal can be passed from cell to cell from the port to control data shifting movements in each connected cell.

According to the present invention there is provided an integrated circuit including a data port and a plurality of data processing cells on a semiconductor wafer, at least some of said cells being connectable to neighbouring cells for data transfer to form a chain of cells starting at said port; where transfer of data between said cells in said chain is controlled by a clock signal; where each of said cells in said chain includes means operative to propogate said clock signal from cell to cell along said chain including clock signal input logic for receiving said clock signal from a first neighbouring cell and clock signal output logic for providing said clock signal to a selectable one other neighbouring cell, said clock signal input logic being operable subsequently to having received said clock signal from said first neighbouring cell to prevent receipt of said clock signal from any other neighbouring cell; where each of said cells in said chain includes a first data path for receiving data from said first neighbouring cell and passing data received from said first neighbouring cell to said selected one other neighbouring cell and a second data path for receiving data from said selected one other neighbouring cell and for passing said data from said selected one other neighbouring cell to said first neighbouring cell; and where each of said cells in said chain includes a clock generator coupled to receive said clock signal from said input logic, operative to provide a first internal clock signal for controlling movement of data in said first data path and a second internal clock signal for controlling movement of data in said second data path.

In a preferred embodiment the wafer scale integrated circuit comprises a plurality of shift register memory storage cells. Starting at a coupling port, the cells are preferably individually accessible for testing and thereafter, if they pass a functional test, are incorporable into a serial shift register memory starting at the port. Each cell, once incorporated into the shift register memory, is preferably operable to couple to a selectable neighbouring cell, provided that neighbouring cell is not already so incorporated, for the testing and subsequent incorporation of that neighbouring cell into the shift register memory if the neighbouring cell works. The result of this testing and incorporation routine is preferably the establishment of one or more data storage chains on the wafer scale circuit, the chain or chains starting and ending on the same port or ports as they started. The storage cells preferably comprise a forward data storage shift register and a reverse data storage shift register, in which case data passes through a particular cell from that cell next nearer to the port in a chain via the forward register and back towards the port from that cell next further away in the chain via the reverse register. The data exiting from the forward register in the last cell in the chain preferably loops back into the reverse register of that last cell. The data storage cell which is in receipt of the output of the forward register of a particular cell is preferably the cell which provides the input to the reverse register of that particular cell.

Each cell preferably comprises a clock generation circuit in receipt of a master clock signal from the cell next nearer the port in a chain. The clock generator preferably provides a first clock signal to control the acceptance of data by and movement of data along the forward register and a second clock signal for controlling the acceptance of data by and movement of data along the reverse register.

Each particular cell preferably comprises a data steering circuit for controlling the coupling of data to a selectable one of the neighbouring cells as the next further away cell from the port in a chain, in which case each cell also comprises a clock steering circuit for providing the master clock signal, received by the particular cell from the cell next nearer the port, as the master clock input to the following cell next further from the port in the chain as defined by the data coupling of the data steering circuit.

The invention is further explained, by way of an example, by the following description in conjunction with the appended drawings, in which:

Figure 1 shows a wafer scale integrated circuit as it physically is laid down on a semiconducting substrate.

Figure 2 shows the structure of the chain of individual cells on the wafer;

Figure 3 shows the inter-cell coupling;

Figure 4 shows the internal structure of a cell;

Figure 5 shows a simplified schematic drawing of the cells coupled in a chain.

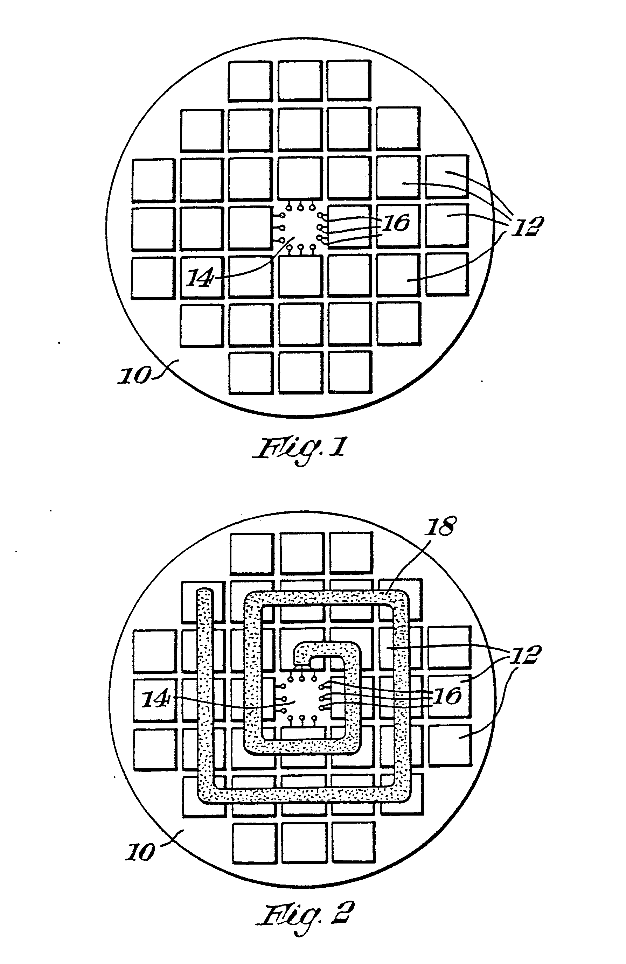

Figure 1 shows the physical layout of the wafer scale integrated circuit.

A circular semiconducting wafer substrate 10 has fabricated thereon a plurality of square, shift register data storage cells 12. The cells 12 form a regular tesselation across the surface of the wafer 10 with the exception of the omission of one cell from the tesselation to form a coupling port 14. The coupling port 14 is preferably but not necessarily at or near the centre of the wafer 10. The cells 12 bordering the coupling port 14 are provided with coupling pads 16 by which they may be connected to the outside world.

The cells 12 are operable to couple to any selectable one neighbouring cell 12 for the transfer of data thereto and therefrom. Starting at the port 14, one of the neighbouring cell 12 to the port 14 is subjected to a functional test from the port 14 via the coupling pads 16. If the cell 12 passes the functional test, it is instructed to couple to a further neighbouring cell 12 and that further cell 12 is tested.

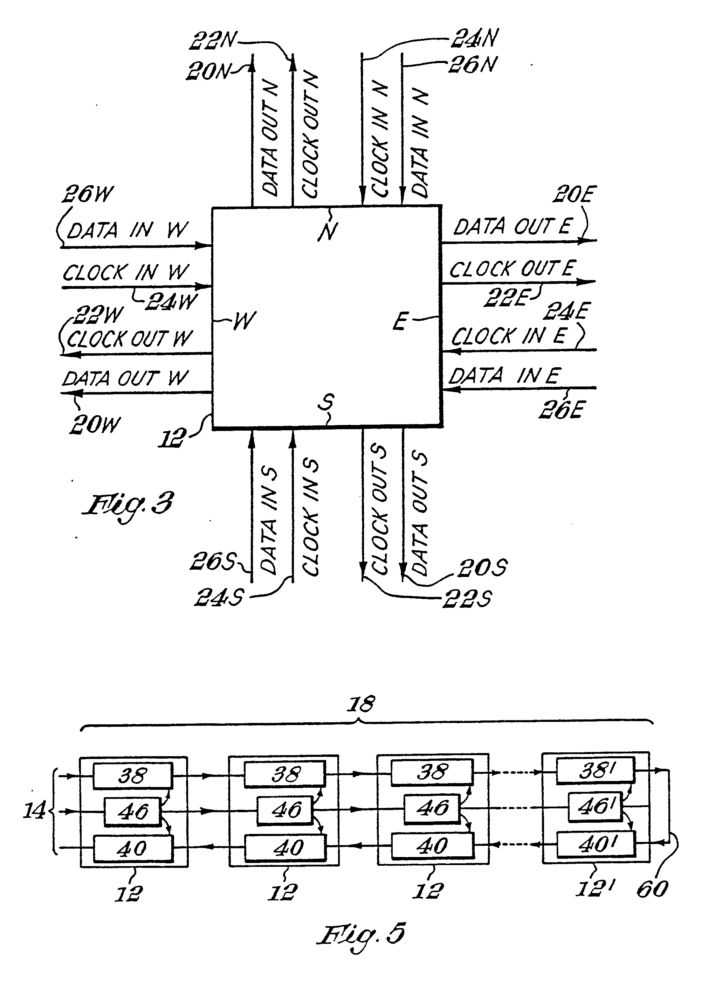

Figure 2 shows how the cells 12 can be formed into a data storage chain 18 on the wafer. It is to be understood that cells 12 which do not pass the functional test can be omitted from the chain 18 by its being steered around their positions.

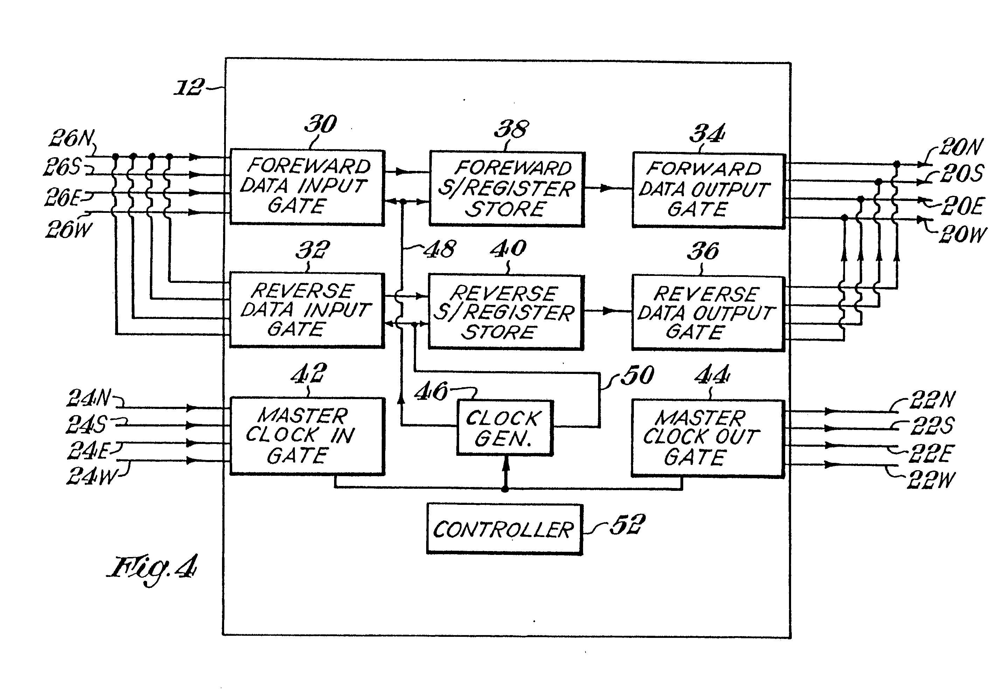

Figure 3 shows the connections on the boundaries of a cell 12.

The square cell 12 has four boundaries, designated the north boundary N, the south boundary S, the east boundary E and the west boundary W. The north boundary N is contiguous with the south boundary S of a first neighbouring cell 12. The east boundary E is contiguous with the west boundary W of a second neighbouring cell 12, the south boundary S is contiguous with the north boundary N of a third neighbouring cell 12 and the west boundary W is contiguous with the east boundary E of a fourth neighbouring cell 12.

Each boundary N, S, E, W has a first line 20N, 20S, 20E, 20W respectively for transferring data out of the cell 12 to a neighbouring cell 12. Each boundary N, S, E, W, has a second line 22N, 22S, 22E, 22W respectively for transferring the master clock signal to a neighbouring cell 12. Each boundary N, S, E, W has a third line 24N, 24S, 24E, 24W respectively for receiving the master clock signal from a neighbouring cell. Each boundary N, S, E, W has a fourth line 26N, 26S, 26E, 26W for receiving data from a neighbouring cell. Table 1 shows the interconnection between the lines shown and the lines on the neighbouring cells.

TABLE 1
Inter-Cell Connections

20N joins to 26S of neighbouring cell to North
22N joins to 24S of neighbouring cell to North
24N joins to 22S of neighbouring cell to North
26N joins to 20S of neighbouring cell to North
20E joins to 26W of neighbouring cell to East
22E joins to 24W of neighbouring cell to East
24E joins to 22W of neighbouring cell to East
26E joins to 20W of neighbouring cell to East
20S joins to 26N of neighbouring cell to South
22S joins to 24N of neighbouring cell to South
24S joins to 22N of neighbouring cell to South
26S joins to 20N of neighbouring cell to South
20W joins to 26E of neighbouring cell to West
22W joins to 24E of neighbouring cell to West
24W joins to 22E of neighbouring cell to West
26W joins to 20E of neighbouring cell to West.

It is seen that a cell 12 can pass data and clock signals to and receive data and clock signals from any neighbouring cell 12.

Figure 4 shows the internal structure of a cell 12.

The input and output lines to the cell 12 are shown dissociated from their associated boundaries N, S, E, W to enhance the clarity of the figure.

The data input lines 26N, 26S, 26E, 26W are provided as the inputs to a forward data input gate 30 and to a reverse data input gate 32. The data output lines 20N, 20S, 20E, 20W are provided as the output of a forward data output gate 34 and of a reverse data output gate 36.

The forward data input gate 30 selects the signal from one of the data input lines 26N, 26S, 26E, 26W for provision as input to a forward data shift register store 38. The reverse data input gate 32 selects the signal from another of the data input lines 26N, 26S, 26E, 26W as the input to a reverse data shift register store 40.

The forward data store 38 and the reverse data store 40 can both be the same length and each comprise a plurality of shift register, bit storage cells coupled in tandem, or they can be of different lengths. After a predetermined number of clock pulses have been applied to a clock input to each of the stores 38, 40, the informational data originally presented at their input reappears at their output. Similarly, the stores 38, 40, according to various proposed and known cell configurations, can be means whereby data can be stored in or retrieved from other, main storage elements in the cell 12 as well as passed through the cell 12 up and down the chain 18.

The output of the forward data store 38 is provided as the input to the forward data output gate 34 which provides the output of the store 38 as the signal on a selectable one of the data output lines 20N, 20S, 20E, 20W. The output of the reverse data store 40 is provided as the input to the reverse data output gate which provides the output of the reverse store 40 as the signal on another selectable one of the data output lines 20N, 20S, 20E, 20W.

The master clock input lines 24N, 24S, 24E, 24W are provided as the inputs to the master clock input gate which provides, as its output, the signal on a selectable one of the lines 24N, 24S, 24E, 24W. The output of the master clock input gate is provided firstly as the input to a master clock output gate 44 which provides, as its output, the signal on its input to a selectable one of the master clock output lines 22N, 22S, 22E, 22W. The output of the master clock input gate 42 is provided secondly as the input to a clock signal generator 46. The clock signal generator 46 generates a first clock signal on a first clock line 48 for controlling the data acquisition activity of the forward data input gate 30 and the data shifting activity of the forward store 38, and a second clock signal on a second clock line 50 for controlling the data acquisition activity of the reverse data input gate 32 and for controlling the data shifting activity of the reverse store 40.

The switching action of the gates 30, 32, 34, 36, 42 and 44 is determined by the state of a controller 52 which is coupled to control each of them to select in the case of the input gates 30, 32, 42, from which line a signal will be received or in the case of the output gates 34, 36, 44 to which line a signal will be delivered up. The exact manner in which the controller 52 receives instructions to be in a particular state does not constitute part of the present invention. The state of the controller 52 can be established via Global control signals, command words intermingled with data, and the like, those skilled in the art being aware of numerous other ways in which this aim can be accomplished.

The switching control action of the controller 52 is shown in table 2. As is seen, at any one time one face N, S, E or W of the cell 12 is selected as the source of forward data as a source of the master clock signal and as a sink for the reverse data, and another face N, S, E or W of the cell 12 is chosen as the sink for the forward data, as the sink for the master clock signal, and as the source of the reverse data.

4

TABLE 2
Input and Output Routing Function of the Cell (12)

| Source of Forward Data Input (to 38) | Source of Master Clock Input (to 46, 44) | Sink for Forward Data Output (from 38) | Source of Reverse Data Input (to 40) | Sink for Reverse DATA OUTPUT (from 40) | Sink for Master Clock Output (from 42) |
|---|---|---|---|---|---|
| 26N | 24N | NOT 20N | NOT 26N | 20N | NOT 22N |
| 26S | 24S | NOT 20S | NOT 26S | 20S | NOT 22S |
| 26E | 24E | NOT 20E | NOT 26E | 20E | NOT 22E |
| 26W | 24W | NOT 20W | NOT 26W | 20W | NOT 22W |
| NOT 26N | NOT 24N | 20N | 26N | NOT 20N | 22N |
| NOT 26S | NOT 24S | 20S | 26S | NOT 20S | 22S |
| NOT 26E | NOT 24E | 20E | 26E | NOT 20E | 22E |
| NOT 26W | NOT 24W | 20W | 26W | NOT 20W | 22W |

Figure 5 shows a simplified configuration of the memory chain 18 which is formed on the wafer scale circuit.

The forward registers 38 of the cells 12 are coupled in series. The reverse registers 40 of the cells 12 are similarly coupled in series. The chain of forward registers 38 leads data from the port 14 to a last cell 12' and the chain of reverse registers 40' lead data back from the last cell 12' to the port 14. The last cell 12' has a loop data coupling 60 whereby the output of the last cell forward register 38' is provided as the input to the last cell reverse register 40'. All cells 12 have the facility for forming the loop coupling 60, but it is only used in that cell 12' which happens to find itself at the end of the chain.

The master clock signal is coupled from the port 16 from clock generator 46 to clock generator 46 along the chain 18 up to and including the clock generator 46' of the last cell 12'. There being no cell 12 beyond the last cell 12', the propagation of the master clock signal stops thereat.

The master clock signal is passed on by the clock generators 46 from cell 12 to cell, and is subject to a delay between the cells. If the delay in propagating the clock signal between cells 12 is designated by Td, then the clock signal will reach the Nth cell away from the port NTd later than if it had been propagated in the usual manner by parallel Global lines to all cells at the same time. If the last cell 12' is the Mth cell counting from the port 14, then forward data enters the last cell 12' MTd late. However, the same clock signal is used to clock the forward data as is used to control the flow of reverse data. The flow of data, in passing from the forward to the reverse direction, experiences an advance in position relative to the propagated clock signal which increases with the distance a cell 12 is away from the last cell 12' in the direction of the port 14.

The clocked forward data, in coming back from the last cell 12' encounters the forward propagated master clock signal not with increasing lateness, as had been the case in the propagation of the data in the forward chain, but with increasing earliness. This lateness and earliness is of course measured with respect to the application of the master clock signal at the port 14 to the first cell 12. By the time the data has arrived back at the port 14 it has caught up all of its delays and the flow of data into and out of the chain 18 at the port takes place as if the clock signal were distributed to the cells 12 in the usual, globally connected way.

The operation of the clocking circuit has here been described with reference to a hypotheyically constantly moving data stream up and down the chain 18.

The present invention works equally well in any chain-connectable wafer-scale integrated circuit having a forward data path and a reverse data path. Those skilled in the art will be aware of many variations on this type of chain connectable wafer-scale circuit.

Equally well the present invention might be employed in a wafer-scale circuit wherein data enters a directional chain at one port and leaves at another, the clock signal being propagated therebetween from the data entry port to the data exit port.

The invention equally applies to those circuits where data is propagated only so far down a chain for storage in a selectable cell, and where data is retrieved from storage from a selectable cell in the chain to be propagated back to a port.

It is to be noted that the clock generator 46 can be of any kind consistent with the operation of the particular type of cell in conjunction with which the present invention is applied. In particular it is advantageous that the clock generator 46 includes clock signal buffering means to prevent progressive

5

**0 097 148**

attenuation of the master clock signal as it progresses down the chain.

The cells need not be four-sided, nor need the clock and data signals be propagatable across every edge of the cells. The cells need not necessarily be all of the same shape or function. The present invention might equally be used to clock data into and out of, for example, arithmetic units in a wafer scale processor integrated circuit.

## Claims

1. An integrated circuit including a data port (14) and a plurality of data processing cells (12) on a semiconductor wafer (10), at least some of said cells (12) being connectable to neighbouring cells (12) for data transfer to form a chain (18) of cells (12) starting at said port (14), where transfer of data between said cells (12) in said chain (18) is controlled by a clock signal (22, 24); where each of said cells (12) in said chain (18) includes means (42, 44) operative to propagate said clock signal (22, 24) from cell (12) to cell (12) along said chain (18) including clock signal input logic (42) for receiving said clock signal (24) from a first neighbouring cell (12) and clock signal output logic (44) for providing said clock signal (22) to a selectable one other neighbouring cell (12), said clock signal input logic (42) being operable subsequently to having received said clock signal (24) from said first neighbouring cell (12) to prevent receipt of said clock signal (24) from any other neighbouring cell (12); where each of said cells (12) in said chain (18) includes a first data path (30, 34, 38) for receiving data (26) from said first neighbouring cell (12) and passing data (20) received from said first neighbouring cell (12) to said selected one other neighbouring cell (12) and a second data path (32, 36, 40) for receiving data (26) from said selected one other neighbouring cell (12) and for passing said data (20) from said selected one other neighbouring cell (12) to said first neighbouring cell (12); and where each of said cells (12) in said chain (18) includes a clock generator (46) coupled to receive said clock signal (24) from said input logic (42), operative to provide a first internal clock signal (48) for controlling movement of data in said first data path (30, 34, 38) and a second internal clock signal (50) for controlling movement of data in said second data path (32, 36, 40).

2. An integrated circuit according to Claim 1 wherein said first data path (30, 34, 38) includes a first data storage shift register (38) and wherein said second data path (32, 36, 40) includes a second data storage shift register (40).

3. An integrated circuit according to Claim 1 or Claim 2 wherein said each one of said cells (12) in said chain (18) comprises wrap-around logic (60) operable in default of a command to said clock signal output logic (44) to provide said clock signal (22) to a selectable other neighbouring cell (12) to couple the output (20) of said first data path (30, 34, 38) as the input to said second data path (32, 36, 40).

4. An integrated circuit according to any of the preceding Claims wherein said cells (12) are square and form a regular tesselation on said wafer (10).

5. An integrated circuit according to Claim 4 wherein said port (14) is formed by the omission of a cell (12) from said tesselation and the provision of coupling (16) to one or more cells (12) adjacent thereto.

## Patentansprüche

1. Integrierte Schaltung mit einem Datenanschluß (14) und mehreren Datenverarbeitungszellen (12) auf einem Halbleiterplättchen (10), von denen mindestens einige Zellen (12) mit Nachbarzellen (12) zum Datentransfer unter Bildung einer Kette (18) von Zellen (12) verbindbar sind, die an dem Anschluß (14) beginnt, wobei die Datenübertragung zwischen den Zellen (12) in der Kette (18) mittels eines Taktsignals (22, 24) gesteuert wird; wobei jede der Zellen (12) in der Kette (18) eine Einrichtung (42, 44) enthält, die das Taktsignal (22, 24) von Zelle (12) zu Zelle (12) entlang der Kette (18) weiterleitet und eine Taktsignal-Eingangslogik (42) zum Empfang des Taktsignals (24) von einer ersten Nachbarzelle (12) und eine Taktsignal-Ausgangslogik (44) enthält, die das Taktsignal (22) an eine wählbare andere Nachbarzelle (12) abgibt, wobei die Taktsignal-Eingangslogik (42) nach dem Empfang des Taktsignales (24) von der ersten Nachbarzelle (12) den Empfang des Taktsignals (24) von irgendeiner anderen Nachbarzelle (12) verhindert; wobei jede der Zellen (12) in der Kette (18) einen ersten Datenpfad (30, 34, 38) zum Empfang von Daten (26) von der ersten Nachbarzelle (12) und zum Weiterleiten der von der ersten Nachbarzelle (12) empfangenen Daten (20) an die ausgewählte andere Nachbarzelle (12) weiterleitet und einem zweiten Datenpfad (32, 36, 40) enthält, der Daten (26) von der ausgewählten anderen Nachbarzelle (12) empfängt und die Daten (20) von der ausgewählten anderen Nachbarzelle (12) an die erste Nachbarzelle (12) weiterleitet; und wobei jede der Zellen (12) in der Kette (18) einen Taktgenerator (46) enthält, der das Taktsignal (24) von der Eingangslogik (42) empfängt und ein erstes internes Taktsignal (48) zur Steuerung der Bewegung der Daten in dem ersten Datenpfad (30, 34, 38) und ein zweites internes Taktsignal (50) zur Steuerung der Bewegung der Daten in dem zweiten Datenpfad (32, 36, 40) abgibt.

2. Integrierte Schaltung nach Anspruch 1, dadurch gekennzeichnet, daß der erste Datenpfad (30, 34, 38) ein erstes Datenspeicher-Schieberegister (38) und der zweiten Datenpfad (32, 36, 40) ein zweites Datenspeicher-Schieberegister (40) enthält.

3. Integrierte Schaltung nach Anspruch 1 oder 2, dadurch gekennzeichnet, daß jede der Zellen (12) in der Kette (18) eine zyklische Folgelogik (60) enthält, die bei Fehlen eines Befehls an die Taktsignal-Ausgangslogik (44) das Taktsignal (22) an eine wählbare andere Nachbarzelle (12) abgibt, um den Ausgang

6

(20) des ersten Datenpfades (30, 34, 38) als Eingang an den zweiten Datenpfad (32, 36, 40) einzukoppeln.

4. Integrierte Schaltung nach einem der vorstehenden Ansprüche, dadurch gekennzeichnet, daß die Zellen (12) quadratisch sind und ein regelmäßiges Mosaik auf dem Plättchen (10) ausbilden.

5. Integrierte Schaltung nach Anspruch 4, dadurch gekennzeichnet, daß der Anschluß (14) durch Auslassen einer Zelle (12) aus dem Mosaik gebildet wird und eine Verbindung (16) zu einer oder mehreren zu ihr benachbarte Zellen (12) hergestellt wird.

## Revendications

1. Circuit intégré comportant un port de données (14) et un ensemble de cellules de traitement de données (12) sur une plaquette semi-conductrice (10), au moins certaines des cellules (12) pouvant être reliées à des cellules voisines (12) pour le transfert des données et former une chaîne (18) de cellules (12) commençant à ce port (14), ce transfert des données entre les cellules (12) de la chaine (18) étant commandé par un signal d'horloge (22, 24) chacune des cellules (12) de la chaîne (18) comprenant un moyen (42, 44) faisant propager le signal d'horloge (22, 24) d'une cellule (12) vers une cellule (12) le long de la chaîne (18), ce moyen comprenant une logique d'entrée de signal d'horloge (42) recevant le signal d'horloge (24) d'une première cellule voisine (12) et une logique de sortie de signal d'horloge (44) fournissant le signal d'horloge (22) à une autre cellule voisine (12) choisie, la logique d'entrée de signal d'horloge (42) pouvant être mise en oeuvre après avoir reçu le signal d'horloge (24) de la première cellule voisine (12) pour éviter la réception du signal d'horloge (24) de n'importe quelle cellule voisine (12), chacune des cellules (12) de la chaîne (18) comprenant un premier chemin de données (30, 34, 38) pour recevoir les données (26) de la première cellule voisine (12) et faire passer les données (20) reçues de la première cellule voisine (12) vers une autre cellule voisine (12) et un second chemin de données (32, 36, 40) pour recevoir les données (26) d'une autre cellule voisine choisie (12) et faire passer les données (20) d'une autre cellule voisine (12) choisie vers la première cellule voisine (12), et chacune des cellules (12) de la chaîne (18) comprenant un générateur d'horloge (46) branché de manière à recevoir le signal d'horloge (24) de la logique d'entrée (42) pour fournir un premier signal d'horloge (48) commandant le mouvement des données dans le premier chemin de données (30, 34, 38) et un second signal d'horloge interne (50) pour commander le mouvement des données dans le second chemin de données (32, 36, 40).

2. Circuit intégré selon la revendication 1, caractérisé en ce que le premier chemin de données (30, 34, 38) comprend un premier registre à décalage de stockage de données (38) et le second chemin de données (32, 36, 40) comporte un second registre de décalage de stockage de données (40).

3. Circuit intégré selon la revendication 1 ou la revendication 2, caractérisé en ce que chacune des cellules (12) de la chaîne (18) comporte une logique bouclée (60) mise en oeuvre en cas de défaut d'ordre pour que la logique de sortie de signal d'horloge (44) fournisse le signal d'horloge (22) à une autre cellule voisine choisie (12) pour coupler la sortie (20) du premier chemin de données (30, 34, 38) comme entrée du second chemin de données (32, 36, 40).

4. Circuit intégré selon l'une quelconque des revendications précédentes, caractérisé en ce que les cellules (12) sont des réseaux rectangulaires, de forme régulière, réalisés sur la plaquette (10).

5. Circuit intégré selon la revendication 4, caractérisé en ce que le port (14) est formé par la suppression d'une cellule (12) du réseau et la réalisation du couplage (16) sur une ou plusieurs cellules (12) adjacentes.

*Fig. 1*

*Fig. 2*

Fig. 3

Fig. 5

Fig.4

0 097 148